# EUROPÄISCHE PATENTSCHRIFT

(11) **EP 3 667 831 B1**
(45) Veröffentlichungstag und Bekanntmachung des Hinweises auf die Patenterteilung: **27.04.2022**
(21) Anmeldenummer: 19209323.5
(22) Anmeldetag: 15.11.2019
(51) Int. Cl.: H01R 13/24, H01R 13/66, B60L 53/16, B60L 53/62, H01R 12/57, H01R 12/71

(54) **STECKVERBINDERTEIL MIT EINER LEITERPLATTE**
CONNECTOR PART WITH A CIRCUIT BOARD
PIÈCE DE CONNECTEUR ENFICHABLE DOTÉE D'UNE CARTE DE CIRCUIT IMPRIMÉ

(30) Priorität: 10.12.2018 BE 201805869
(43) Veröffentlichungstag der Anmeldung: 17.06.2020
(73) Patentinhaber: Phoenix Contact e-Mobility GmbH, 32816 Schieder-Schwalenberg (DE)
(72) Erfinder: GARTH, Carsten, 32657 Lemgo (DE); FELDNER, Ralf, 32805 Horn-Bad Meinberg (DE); GEBHARDT, Tanja, 33189 Schlangen (DE)
(74) Vertreter: Muth, Bruno

(56) Entgegenhaltungen:
- DE-A1-102016 211 876
- DE-U1-202017 105 818

## Beschreibung

Die Erfindung betrifft ein Steckverbinderteil zum steckenden Verbinden mit einem Gegensteckverbinderteil nach dem Oberbegriff des Anspruchs 1.

Ein derartiges Steckverbinderteil umfasst ein Gehäuseteil, ein an dem Gehäuseteil geformtes Steckgesicht, über das das Steckverbinderteil steckend mit dem Gegensteckverbinderteil verbindbar ist und an dem eine Mehrzahl von Kontaktelementen zum elektrischen Verbinden mit dem Gegensteckverbinderteil angeordnet ist, und eine Leiterplatte, an der zumindest eine elektrische oder elektronische Funktionskomponente angeordnet ist.

Bei einem solchen Steckverbinderteil kann es sich beispielsweise um einen Stecker oder auch eine Buchse handeln. Ein solches Steckverbinderteil kann insbesondere an einer Ladeeinrichtung zum Übertragen eines Ladestroms zum Einsatz kommen. Das Steckverbinderteil kann insbesondere als Ladestecker oder Ladebuchse zum Laden eines elektromotorisch angetriebenen Kraftfahrzeugs (bezeichnet auch als Elektrofahrzeug) ausgebildet sein und kann auf Seiten einer Ladestation, z.B. als Ladestecker an einem Ladekabel, oder auch auf Seiten eines Fahrzeugs als sogenannter Inlet verwendet werden. Ein Steckverbinderteil nach dem Oberbegriff des Anspruchs 1 ist bekannt aus dem Dokument DE 10 2016 211876 A1.

Ladestecker oder Ladebuchsen zum Aufladen von Elektrofahrzeugen sind so auszulegen, dass große Ladeströme übertragen werden können. Weil die thermische Verlustleistung quadratisch mit dem Ladestrom wächst und zudem vorgeschrieben ist, dass eine Temperaturerhöhung an einem Steckverbinderteil 50 K nicht überschreiten darf, ist bei solchen Ladesteckern oder Ladebuchsen erforderlich, eine Temperaturüberwachung bereitzustellen, um eine Überhitzung an Bauteilen des Ladesteckers oder der Ladebuchse frühzeitig zu erkennen und gegebenenfalls eine Modifizierung des Ladestroms oder gar eine Abschaltung der Ladeeinrichtung zu bewirken. Beispielsweise sind bei einem aus der DE 10 2015 106 251 A1 bekannten Steckverbinderteil Kontaktelemente beispielweise in Öffnungen einer Leiterplatte angeordnet. An der Leiterplatte sind ein oder mehrere Sensoreinrichtungen vorgesehen, die dazu dienen, eine Erwärmung an einem oder mehreren Kontaktelementen zu erfassen.

Um zudem sicherzustellen, dass bei Verbindung eines Elektrofahrzeugs mit einer Ladestation über ein Ladekabel ein in das Elektrofahrzeug eingespeister Ladestrom eine zulässige Maximalstromstärke, für die das Ladekabel und ein Ladesystem des Elektrofahrzeugs ausgelegt sind, nicht überschritten wird, wird an Steckverbinderteilen eine Widerstandskodierung verwendet, wie dies beispielsweise in der DE 10 2010 053 074 A1, der DE 20 2012 100 613 U1 und der DE 10 2013 110 548 A1 beschrieben und zudem in einschlägigen Normen, beispielsweise der IEC 62196, normiert ist. Beispielsweise kann in einem Stecker eines Ladekabels zwischen einem so genannten Näherungskontakt und einem Schutzleiterkontakt ein Widerstand geschaltet sein, dessen Widerstandswert bei Anschließen des Steckers an eine Ladestation über die Ladestation gemessen werden kann, um anhand des Widerstandswerts den Typ des angeschlossenen Ladekabels zu erkennen. Unterschiedlichen Widerstandswerten sind hierbei bestimmte Typen von Ladekabeln oder Ladeeinrichtungen zugeordnet, so dass anhand des Widerstandswerts dieser Typ identifiziert werden kann. Insbesondere kann auf diese Weise eine zulässige Maximalstromstärke, die beispielsweise über ein Ladekabel übertragen werden kann (beispielsweise 16 A oder 32 A) identifiziert werden, so dass entsprechend die Ladestation einen eingespeisten Strom begrenzen kann. Zu ähnlichem Zweck dient eine Widerstandskodierung beispielsweise an einem Steckverbinderteil in Form einer Ladebuchse an einem Elektrofahrzeug. In diesem Fall kann anhand eines Widerstandswerts insbesondere ein maximal zulässiger Ladestrom, für den das Ladesystem des Elektrofahrzeugs ausgelegt ist, identifiziert werden.

Um unterschiedliche elektrische und/oder elektronische Funktionen, zum Beispiel eine Temperarturüberwachung oder eine Widerstandkodierung, an einem Steckverbinderteil zur Verfügung zu stellen, ist herkömmlich bereits vorgesehen worden, eine Leiterplatte mit daran angeordneten Funktionskomponenten in einem Steckverbinderteil anzuordnen. Wünschenswert ist dabei eine platzeffiziente Anordnung der Leiterplatte in dem Steckverbinderteil bei zuverlässiger thermischer und/oder elektrischer Kontaktierung mit zugeordneten Kontaktelementen und einfacher Montage des Steckverbinderteils.

Aufgabe der vorliegenden Erfindung ist es, ein Steckverbinderteil bereitzustellen, das eine platzsparende Anordnung einer Leiterplatte bei vorteilhafter thermischer und/oder elektrischer Kontaktierung mit zugeordneten Kontaktelementen und bei zudem einfacher Montage der Leiterplatte in dem Steckverbinderteil ermöglicht.

Diese Aufgabe wird durch einen Gegenstand mit den Merkmalen des Anspruchs 1 gelöst.

Demnach weist die Leiterplatte eine erste Öffnung auf, durch die ein erstes Kontaktelement der Mehrzahl von Kontaktelementen hindurch erstreckt ist, wobei die Leiterplatte zumindest eine erste Kontaktfeder zum thermischen und/oder elektrischen Kontaktieren mit dem ersten Kontaktelement oder zumindest eine zweite Kontaktfeder zum thermischen und/oder elektrische Kontaktieren mit einem zweiten Kontaktelement der Mehrzahl von Kontaktelementen aufweist.

Die Leiterplatte dient dazu, an dem Steckverbinderteil elektrische und/oder elektronische Funktionen bereitzustellen. Insbesondere kann an Lastkontakten des Steckverbinderteils eine Temperaturüberwachung bereitgestellt werden. Zudem kann über die Leiterplatte beispielsweise eine Widerstandskodierung verwirklicht werden. Die Kontaktelemente des Steckverbinderteils erstrecken sich hierbei beispielsweise axial entlang einer Steckrichtung, entlang derer das Steckverbinderteil mit dem zugeordneten Gegensteckverbinderteil zu verbinden ist. Dadurch, dass ein erstes Kontaktelement eine Öffnung der Leiterplatte durchgreift, kann sich die Leiterplatte vorzugsweise näherungsweise senkrecht zu der Steckrichtung und somit senkrecht zur Längserstreckungsrichtung der Kontaktelemente erstrecken, was ermöglicht, die Leiterplatte bauraumeffizient in dem Gehäuseteil des Steckverbinderteils einzufassen.

Über die an der Leiterplatte angeordneten Kontaktfedern wird eine zuverlässige, einfach herzustellende Kontaktierung zur thermischen und/oder elektrischen Kopplung der Kontaktelemente mit der Leiterplatte bereitgestellt. Bei der Montage des Steckverbinderteils gelangen die zugeordneten Kontaktelemente selbsttätig in Anlage mit zugeordneten Kontaktfedern der Leiterplatte, sodass dadurch eine thermische und/oder elektrische Ankopplung der Kontaktelemente an die Leiterplatte bereitgestellt wird, ohne dass weitere Maßnahmen zur Kopplung der Leiterplatte mit den Kontaktelementen ergriffen werden müssen. Die Kontaktfedern können beispielsweise als oberflächenmontierte (zum Beispiel SMD-gelötete) Federelemente ausgebildet sein, die bei der Montage des Steckverbinderteils selbsttätig unter elastischer Verspannung in Anlage mit den zugeordneten Kontaktelementen gelangen.

Es ergibt sich eine einfache Montage bei bauraumeffizienter Aufnahme der Leiterplatte in dem Gehäuseteil des Steckverbinderteils und bei zudem zuverlässiger thermischer und/oder elektrischer Kontaktierung der Leiterplatte mit zugeordneten Kontaktelementen.

In einer Ausgestaltung sind die zumindest eine erste Kontaktfeder und die zumindest eine zweite Kontaktfeder an unterschiedlichen Seiten der Leiterplatte angeordnet. An einer ersten Seite kann die Leiterplatte beispielsweise eine oder mehrere erste Kontaktfedern zur Kontaktierung mit dem zugeordneten ersten Kontaktelement, beispielsweise einem Lastkontakt, aufweisen. An einer der ersten Seite abgewandten, zweiten Seite weist die Leiterplatte demgegenüber eine oder mehrere zweite Kontaktfedern zur Kontaktierung mit dem zweiten Kontaktelement, beispielsweise einem Signalkontakt, auf. An der Leiterplatte können hierbei jeweils mehrere Gruppen von ersten Kontaktfedern und zweiten Kontaktfedern angeordnet sein, die zur Kontaktierung mit mehreren ersten Kontaktelementen, zum Beispiel mehreren Lastkontakten, und mehreren zweiten Kontaktelementen, zum Beispiel mehreren Signalkontakten, dienen. Die Kontaktfedern sind axial, also senkrecht zur Ebene der Leiterplatte, federnd und gelangen somit bei der Montage des Steckverbinderteils unter axialer Verspannung in Anlage mit den zugeordneten Kontaktelementen.

In einer Ausgestaltung weist das erste Kontaktelement einen die erste Öffnung der Leiterplatte durchgreifenden Schaftabschnitt und einen an dem Schaftabschnitt angeordneten Bund auf. Der Bund steht radial von dem Schaftabschnitt vor und kontaktiert über die zumindest eine erste Kontaktfeder die Leiterplatte thermisch und/oder elektrisch derart, dass über den Bund eine thermische und/oder elektrische Kopplung des Kontaktelements mit der Leiterplatte hergestellt ist. An den Schaftabschnitt kann sich einerseits zum Beispiel ein Kontaktabschnitt, zum Beispiel in Form eines Buchsenabschnitts zum Verwirklichen einer Kontaktbuchse, zum elektrischen Kontaktieren mit einem zugeordneten Gegenkontaktelement eines Gegensteckverbinderteils anschließen, der in das Steckgesicht hineinragt. Andererseits kann an dem Schaftabschnitt ein Anschlussende angeordnet sein, über das eine Leitung an das Kontaktelement angeschlossen werden kann, beispielsweise eine Lastleitung zum Leiten eines Laststroms hin zu dem ersten Kontaktelement.

Ist die zumindest eine erste Kontaktfeder mit dem Bund des ersten Kontaktelements in Anlage, so kann die Leiterplatte vorzugsweise axial zwischen dem Bund und dem zweiten Kontaktelement abgestützt und somit - zumindest bei der Montage - axial schwimmend in Position gehalten werden. Über die zumindest eine zweite Kontaktfeder ist die Leiterplatte elastisch federnd zum Beispiel zu einem Ende des zweiten Kontaktelements abgestützt. Die Leiterplatte wird somit in elastischer Weise zwischen dem Bund des ersten Kontaktelements und dem zweiten Kontaktelement gehalten, was die Montage der Leiterplatte in dem Gehäuseteil des Steckverbinderteils unempfindlich gegenüber Toleranzen macht und zum Beispiel das Verwenden von Leiterplatten unterschiedliche Stärke ohne bauliche Anpassung anderer Baugruppen des Steckverbinderteils ermöglicht.

Nach dem Anordnen an dem Gehäuseteil (und einem zunächst schwimmenden axialen Halt) ist hierbei möglich, die Leiterplatte axial zu dem Gehäuseteil festzulegen, beispielsweise durch Verstemmen von an der Leiterplatte oder dem Gehäuseteil angeordneten Befestigungsdomen.

Das erste Kontaktelement kann beispielsweise einen Lastkontakt zum Betreiben eines Laststroms, zum Beispiel eines Ladestroms zum Aufladen eines Elektrofahrzeugs, verwirklichen. Weil es an einem solchen Lastkontakt im Betrieb des Steckverbinderteils zu einer Erwärmung kommen kann, ist an dem ersten Kontaktelement vorzugsweise eine Temperaturüberwachung vorgesehen, die dadurch ermöglicht wird, dass das erste Kontaktelement über die zumindest eine erste Kontaktfeder thermisch mit der Leiterplatte verbunden ist, sodass Wärme von dem ersten Kontaktelement hin zu der Leiterplatte und hin zu einem an der Leiterplatte angeordneten Temperatursensor geleitet werden kann, um über den Temperatursensor eine Erwärmung an dem ersten Kontaktelement zu erfassen.

Die Leiterplatte kann beispielsweise eine Steuereinrichtung aufweisen, der Sensorsignale des Temperatursensors zugeleitet werden, wobei die Steuereinrichtung ausgebildet sein kann, die Sensorsignale auszuwerten und gegebenenfalls geeignete Gegenmaßnahmen einzuleiten (zum Beispiel einen Ladevorgang zu unterbrechen), wenn eine (übermäßige) Erwärmung an dem ersten Kontaktelement erkannt wird.

Ein solcher Temperatursensor kann beispielsweise durch einen temperaturabhängigen Widerstand ausgebildet sein. Bei einem solchen Temperatursensor kann es sich beispielsweise um einen Widerstand mit einem positiven Temperaturkoeffizienten (sogenannte PTC-Widerstand) handeln, dessen Widerstandswert mit steigender Temperatur ansteigt (auch bezeichnet als Kaltleiter, der bei niedriger Temperatur eine gute elektrische Leitfähigkeit und bei höheren Temperaturen eine reduzierte elektrische Leitfähigkeit aufweist). Solch ein Temperatursensor kann beispielsweise auch eine nichtlineare Temperaturkennlinie aufweisen und kann beispielsweise aus einem Keramikmaterial hergestellt sein (sogenannter Keramik-Kaltleiter).

Es kann alternativ beispielsweise aber auch ein elektrischer Widerstand mit negativem Temperaturkoeffizienten (sogenannte NTC-Widerstände) als Temperatursensor zum Einsatz kommen, dessen Widerstandswert mit steigender Temperatur sinkt.

Alternativ oder zusätzlich kann auch ein durch ein Halbleiterbauelement ausgebildeter Temperatursensor zum Einsatz kommen.

In einer Ausgestaltung verwirklicht das zweite Kontaktelement einen Signalkontakt zum Übertragen oder Erfassen von Steuersignalen. Bei einem Steckverbinderteil im Rahmen eines Ladesystems zum Aufladen eines Elektrofahrzeugs können über solche Signalkontakte beispielsweise Steuersignale übertragen werden, die einen Ladevorgang steuern und über die zum Beispiel Kontrollsignale zwischen einem Fahrzeug und einer Ladestation ausgetauscht werden. Über einen solchen Signalkontakt werden somit elektrische Signale niedriger Spannung und niedriger Stromstärke zum Austausch von Informationen und Steuerkommandos übertragen. Über die zumindest eine zweite Kontaktfeder kann insbesondere eine elektrische Ankopplung erfolgen, beispielsweise um eine Widerstandskodierung bereitzustellen. Über eine solche Widerstandskodierung kann beispielsweise anhand des Widerstandswertes eines elektrischen Widerstands der Typ eines angeschlossenen Ladekabels oder einer Ladestation oder eine zulässige Maximalstromstärke identifiziert werden.

Zusätzlich oder alternativ kann über die zumindest eine zweite Kontaktfeder auch eine Anschlussleitung mit dem zweiten Kontaktelement verbunden sein. Der Anschlussleitung ist in diesem Fall an die Leiterplatte angeschlossen und elektrisch über die zumindest eine zweite Kontaktfeder mit dem zweiten Kontaktelement gekoppelt. Eine direkte Verbindung der Anschlussleitung mit dem zweiten Kontaktelement zum Beispiel durch Vercrimpen ist in diesem Fall nicht erforderlich, was die Montage des Steckverbinderteils erheblich vereinfacht.

Generell können für solche Kontaktelemente des Steckverbinderteils, die keine Lastströme übertragen, Anschlussleitungen über die Leiterplatte geführt werden, was ermöglicht, eine vormontierte Baueinheit zu schaffen, im Rahmen derer Anschlussleitungen an die Leiterplatte angeschlossen sind und eine Kopplung mit zugeordneten Kontaktelementen dann über Kontaktfedern an der Leiterplatte erfolgt. Dies kann die Herstellung des Steckverbinderteils wesentlich vereinfachen.

In einer Ausgestaltung weist die Leiterplatte eine zweite Öffnung auf, durch die ein drittes Kontaktelement hindurch erstreckt ist, wobei die Leiterplatte zumindest eine dritte Kontaktfeder zum thermischen und/oder elektrischen Kontaktieren mit dem dritten Kontaktelement aufweist. Bei dem dritten Kontaktelement kann es sich beispielsweise um einen Erdungskontakt (so genannter PE-Kontakt) handeln, über den eine Erdung an dem Steckverbinderteil zur Verfügung gestellt wird. Über eine oder mehrere dritte Kontaktfedern kann das dritte Kontaktelement hierbei insbesondere elektrisch mit der Leiterplatte verbunden sein, wobei das dritte Kontaktelement über die Leiterplatte und einen an der Leiterplatte angeordneten elektrischen Widerstand mit dem zweiten Kontaktelement verbunden ist, um auf diese Weise durch einen zwischen das dritte Kontaktelement und das zweite Kontaktelement geschalteten elektrischen Widerstand eine Widerstandskodierung an dem Steckverbinderteil zur Verfügung zu stellen.

Das Steckverbinderteil weist, in einer Ausgestaltung, einen Signalkontaktträger auf, der die Leiterplatte zur Fixierung des zweiten Kontaktelements an dem Gehäuseteil an einer ersten Durchflussöffnung durchgreift. Der Signalkontaktträger dient insbesondere dazu, das zweite Kontaktelement, das beispielsweise einen Signalkontakt verwirklicht, axial in Position an dem Gehäuseteil zu halten, sodass das zweite Kontaktelement positionsfest an dem Steckgesicht fixiert ist. Der Signalkontraktträger kann hierzu beispielsweise an eine dem zweiten Kontaktelement abgewandten Seite der Leiterplatte angesetzt sein und durchgreift mit einem Fixierelement eine zugeordnete Durchgriffsöffnung an der Leiterplatte, um über das Fixierelement auf das zweite Kontaktelement einzuwirken und dieses zu fixieren. Der Signalkontaktträger ist zum Beispiel über eine andere Gehäusebaugruppe mit dem Gehäuseteil verbunden und zu dem Gehäuseteil festgelegt, sodass über den Signalkontaktträger ein oder mehrere zweite Kontaktelemente zu dem Gehäuseteil fixiert sind.

In einer Ausgestaltung weist das Steckverbinderteil zudem einen mit dem Gehäuseteil verbundenen Lastkontaktträger auf, an dem ein oder mehrere erste Kontaktelemente, insbesondere in Form von Lastkontakten, angeordnet sind. Der Lastkontaktträger kann hierbei die ersten Kontaktelemente in Form der Lastkontakte mechanisch fixieren und somit zu den Gehäuseteil festlegen, wobei der Lastkontaktträger beispielsweise durch die Leiterplatte hindurch greift und somit die Leiterplatte lagert.

Das Steckverbinderteil kann beispielsweise als Ladestecker oder als Ladebuchse eines Ladesystems zum Aufladen eines Elektrofahrzeugs Verwendung finden. Das Steckverbinderteil weist hierzu Kontaktelemente auf, die als Lastkontakte zum Übertragen eines Ladestroms zum Beispiel in Form eines Gleichstroms oder in Form eines Wechselstroms dienen.

Der der Erfindung zugrunde liegende Gedanke soll nachfolgend anhand der in den Figuren dargestellten Ausführungsbeispiele näher erläutert werden. Es zeigen:
- Fig.1: eine schematische Darstellung eines Elektrofahrzeugs mit einem Ladekabel und einer Ladestation zum Aufladen;
- Fig. 2: eine Ansicht eines Steckverbinderteils in Form eines Inlets auf Seiten eines Fahrzeugs;
- Fig. 3: eine rückseitige Ansicht des Steckverbinderteils;
- Fig. 4: eine Seitenansicht des Steckverbinderteils;
- Fig. 5: eine Draufsicht auf der Steckverbinderteil;
- Fig. 6: eine Ansicht des Steckverbinderteils schräg von hinten;
- Fig. 7: eine Teilexplosionsansicht des Steckverbinderteils, schräg von vorne;
- Fig. 8: eine Teilexplosionsansicht des Steckverbinderteils, schräg von hinten;
- Fig. 9: eine Vorderansicht einer in einem Gehäuseteil des Steckverbinderteils aufgenommenen Leiterplatte;
- Fig. 10: eine Seitenansicht der Leiterplatte;
- Fig. 11: eine rückwärtige Ansicht der Leiterplatte;
- Fig. 12: eine Draufsicht auf die Leiterplatte;
- Fig. 13: eine Ansicht der Leiterplatte schräg von vorne;
- Fig. 14: eine Ansicht der Leiterplatte, schräg von hinten;
- Fig. 15: eine Explosionsansicht des Steckverbinderteils; und
- Fig. 16: eine Explosionsansicht des Steckverbinderteils, schräg von vorne.

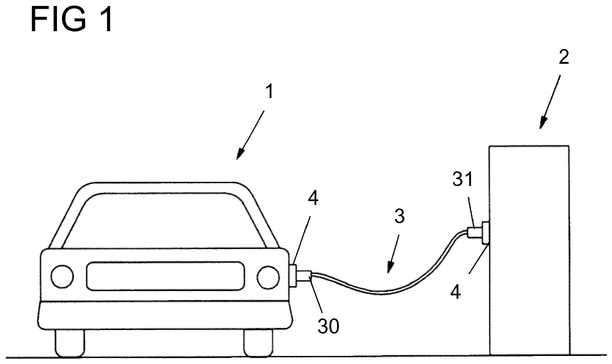

Fig. 1 zeigt in einer schematischen Ansicht ein Fahrzeug 1 in Form eines elektromotorisch angetriebenen Fahrzeugs (bezeichnet auch als Elektrofahrzeug). Das Elektrofahrzeug 1 verfügt über elektrisch aufladbare Batterien, über die ein Elektromotor zum Fortbewegen des Fahrzeugs 1 elektrisch versorgt werden kann.

Um die Batterien des Fahrzeugs 1 aufzuladen, kann das Fahrzeug 1 über ein Ladekabel 3 an eine Ladestation 2 angeschlossen werden. Das Ladekabel 3 kann hierzu mit einem Ladestecker 30 an einem Ende in ein zugeordnetes Steckverbinderteil 4 in Form einer Ladebuchse des Fahrzeugs 1 eingesteckt werden und steht an seinem anderen Ende über einen anderen Ladestecker 31 mit einem Steckverbinderteil 4 in Form einer Ladebuchse an der Ladestation 2 in elektrischer Verbindung. Über das Ladekabel 3 werden Ladeströme mit vergleichsweise großer Stromstärke hin zum Fahrzeug 1 übertragen.

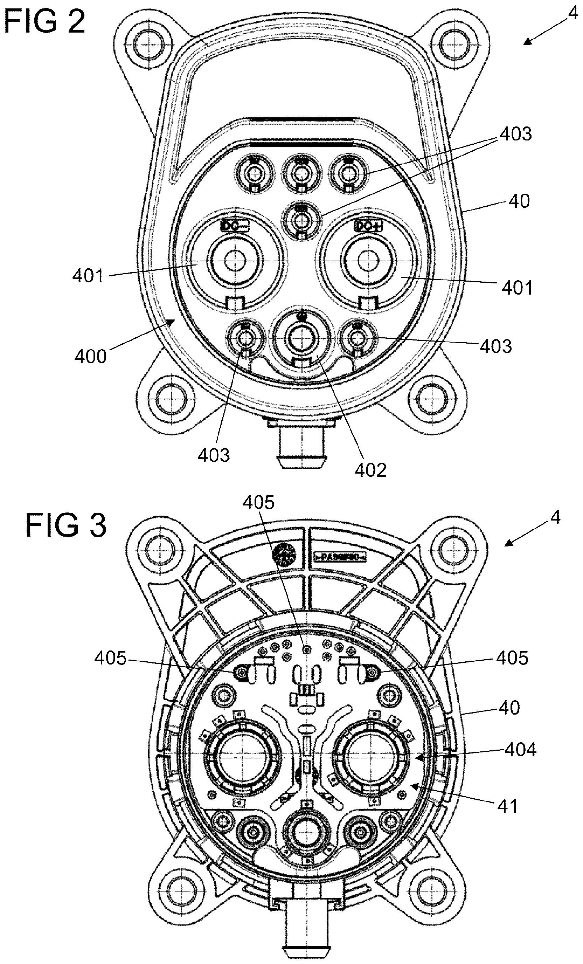

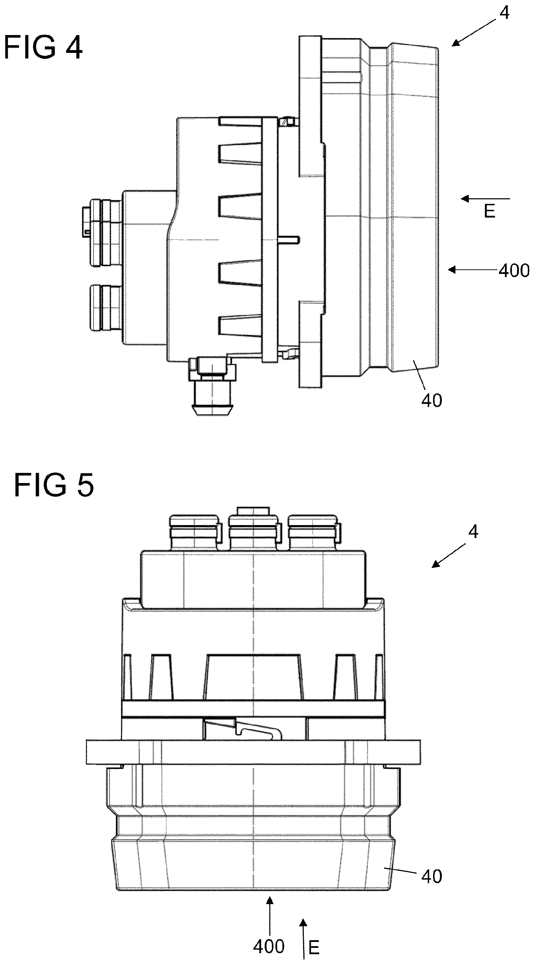

Fig. 2 bis 16 zeigen ein Ausführungsbeispiel eines Steckverbinderteils 4 in Form einer Ladebuchse zum Beispiel auf Seiten eines Fahrzeugs (auch bezeichnet als Fahrzeuginlet), das steckend mit einem zugeordneten Gegensteckverbinderteil 30 in Form eines Ladesteckers an einem Ladekabel 3 verbunden werden kann, um das Elektrofahrzeug 1 mit der Ladestation 2 des Ladesystems zu verbinden. Das Steckverbinderteil 4 weist ein Gehäuseteil 40 auf, an dem ein Steckgesicht 400 geformt ist, mit dem das Gegensteckverbinderteil 30 entlang einer Steckrichtung E steckend verbunden werden kann.

Das Steckgesicht 400 wird gebildet durch Steckdome 401, 402, 403, in denen Kontaktelemente 42, 45, 46, 47 angeordnet sind und über die das Steckverbinderteil 4 entlang der Steckrichtung E steckend mit einem zugeordneten Gegensteckverbinderteil 30 verbunden werden kann. In einem verbundenen Zustand ist über die Steckdome 401, 402, 403 des Steckgesichts 400 eine mechanisch steckende Verbindung mit dem Gegensteckverbinderteil 30 hergestellt, unter elektrischer Kontaktierung der Kontaktelemente 42, 45, 46, 47 mit zugeordneten Gegenkontaktelementen des Gegensteckverbinderteils 30.

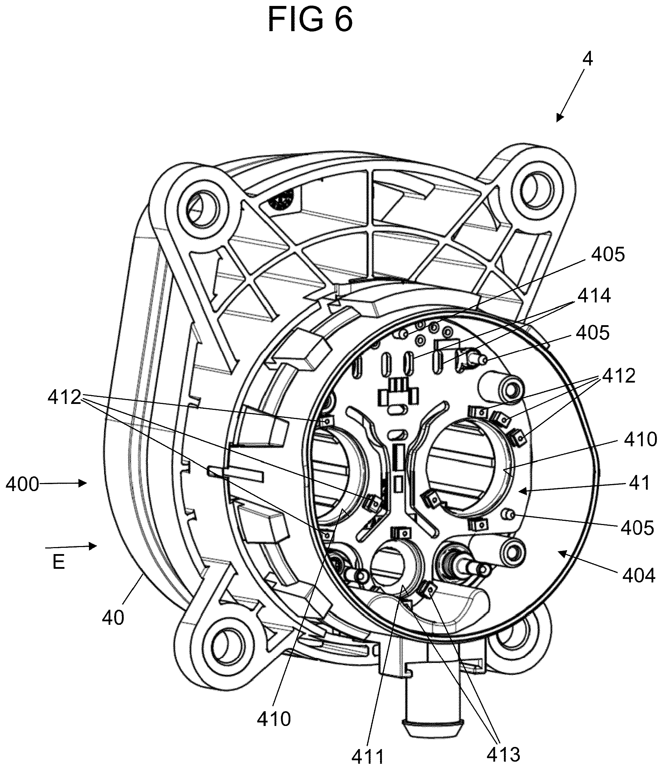

Das Steckgesicht 400 ist an einer Vorderseite des Gehäuseteils 40 geformt. An einer dem Steckgesicht 400 abgewandten Rückseite weist das Gehäuseteil 40 einen Aufnahmeraum 404 (siehe zum Beispiel Fig. 6) auf, in dem eine Leiterplatte 41 mit daran angeordneten elektrischen und/oder elektronischen Funktionskomponenten aufgenommen ist und über den elektrische Kontaktelemente 42, 45, 46, 47 in den Steckdomen 401, 402, 403 des Steckgesichts 400 angeordnet sind.

Die Leiterplatte 41 erstreckt sich entlang einer senkrecht zur Steckrichtung E gerichteten Ebene innerhalb des Aufnahmeraums 404. Die Leiterplatte 41 ist somit senkrecht zur Längserstreckungsrichtung der Kontaktelemente 42, 45, 46, 47 ausgerichtet, sodass die Leiterplatte 41 platzeffizient in dem Aufnahmeraum 404 des Gehäuseteils 40 aufgenommen ist.

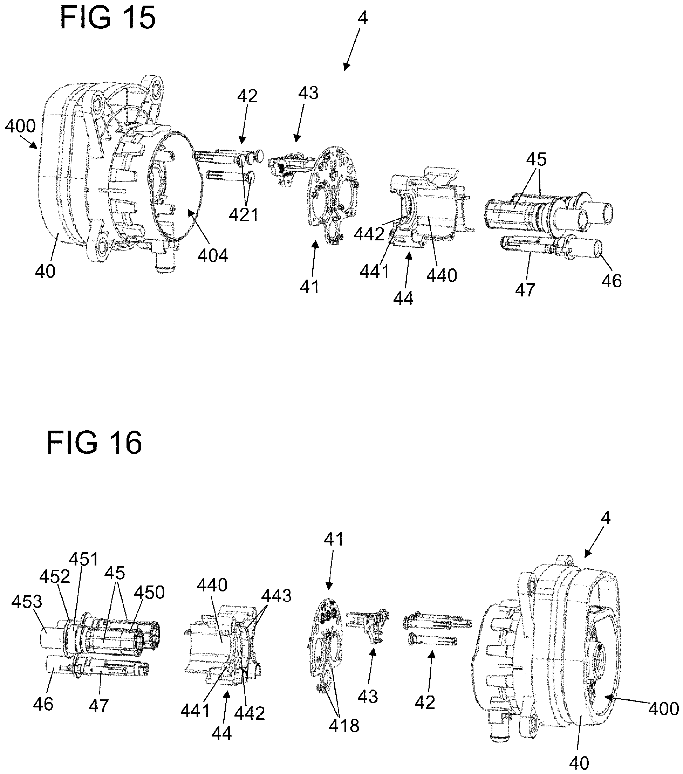

Die Leiterplatte 41 weist zwei erste Öffnungen 410 auf, durch die Kontaktelemente 45 in Form von Lastkontakten hindurch greifen derart, dass die Kontaktelemente 45 mit Kontaktabschnitten 450 in Form von Buchsenabschnitten (siehe Fig. 15 und 16) in den Steckdomen 401 des Steckgesichts 400 zu liegen kommen. Ein radial von einem Schaftabschnitt 451 des jeweiligen Kontaktelements 42 vorstehender Bund 452 kommt hierbei an einer den Steckdomen 401 abgewandten Seite der Leiterplatte 41 zu liegen, und ein an den Bund 452 anschließendes Anschlussende 453 liegt in dem Aufnahmeraum 404 ein, sodass das jeweilige Kontaktelement 45 über das Anschlussende 453 mit einer zugeordneten Lastleitung verbunden werden kann.

Die Leiterplatte 41 weist zudem eine Öffnung 411 auf, die mittig unterhalb der Öffnungen 410 angeordnet ist und durch die ein Kontaktelement 46 in Form eines Erdungskontakts (so genannter PE-Kontakt) hindurch greift derart, dass das Kontaktelement 46 in einen zugeordneten Steckdom 402 des Steckgesichts 400 hineinragt. Ein - analog dem Bund 452 ausgebildeter - Bund des Kontaktelements 46 kommt an der dem Steckdom 402 abgewandten Seite der Leiterplatte 41 zu liegen, sodass das Kontaktelement 46 innerhalb des Aufnahmeraums 404 an eine zugeordnete Erdungsleitung angeschlossen sein kann.

Kontaktelemente 42 in Form von Signalkontakten liegen zudem in Steckdomen 403 oberhalb der den Kontaktelementen 42 in Form der Lastkontakte zugeordneten Steckdome 401 ein und wirken mit der Leiterplatte 41 zusammen.

An der Leiterplatte 41 sind Kontaktfedern 412, 413, 415 zur thermischen und/oder elektrischen Kontaktierung mit den Kontaktelementen 42, 45, 46 angeordnet. Die Kontaktfedern 412, 413, 415 sind zum Beispiel als oberflächenmontierte Federelemente (zum Beispiel SMD-gelötete Federelemente) ausgebildet und stehen axial zu unterschiedlichen Seiten von der Leiterplatte 41 vor.

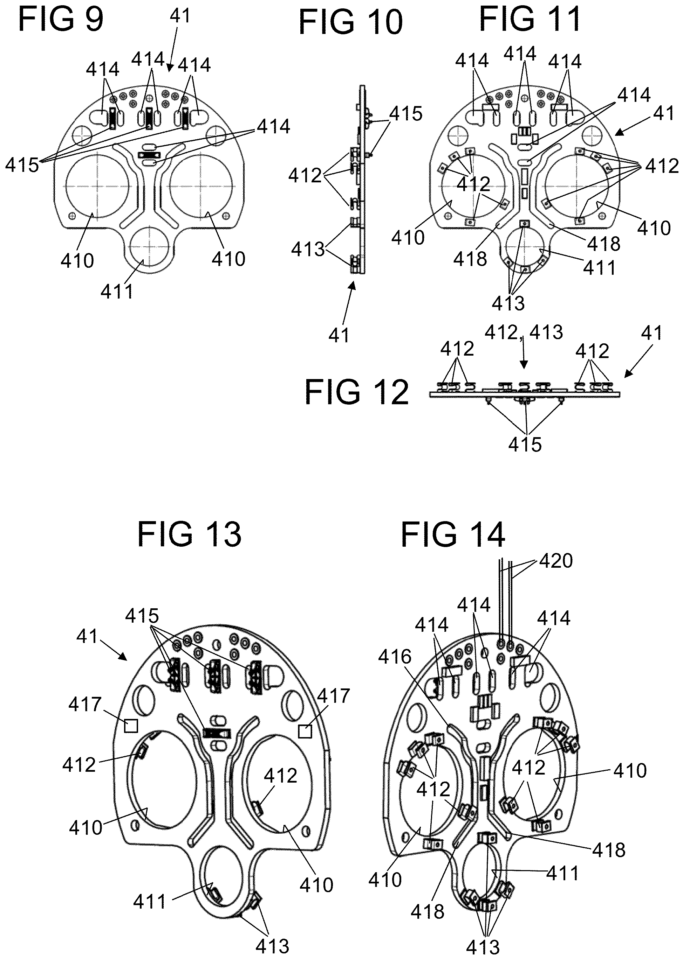

So sind zwei erste Gruppen von Kontaktfedern 412 um die ersten Öffnungen 410 herum gruppiert und dienen dazu, thermisch mit einem Bund 452 an einem Schaftabschnitt 451 eines jeweils zugeordneten Kontaktelements 45 in Form eines Lastkontakts zu kontaktieren, sodass über die Kontaktfedern 412 die Kontaktelemente 45 in Form der Lastkontakte thermisch an die Leiterplatte 41 angebunden sind und Wärme über die Kontaktfedern 412 hin zu der Leiterplatte 41 und somit hin zu einem an der Leiterplatte 41 angeordneten Temperatursensor 417 (siehe Fig. 13) geleitet werden kann. Über die Leiterplatte 41 kann somit eine Temperarturüberwachung an den Kontaktelementen 45 in Form der Lastkontakte bereitgestellt werden.

Die Kontaktelemente 45 in Form der Lastkontakte sind an einem Lastkontaktträger 44 angeordnet und werden über den Lastkontaktträger 44 mechanisch zu dem Gehäuseteil 40 festgelegt und somit in Position zu dem Gehäuseteil 40 gehalten. Die Kontaktelemente 45 greifen jeweils mit ihrem Bund 452 in eine zugeordnete halbkreisförmige Aufnahmenut 441 an einer Aufnahmeeinrichtung 440 des Lastkontaktträgers 44 ein, sodass das jeweilige Kontaktelement 45 durch die zugeordnete Öffnung 410 der Leiterplatte 41 hindurch greift und das dem Kontaktabschnitt 54 abgewandte Anschlussende 453 im Bereich der Anschlusseinrichtung 440 zu liegen kommt. Die Kontaktfedern 412, die um die einem jeweiligen Kontaktelement 45 zugeordnete Öffnung 410 herum gruppiert sind, befinden sich hierbei - betrachtet in Umfangsrichtung um die jeweilige Öffnung 410 - in einem Bereich außerhalb der Aufnahmenut 441 oder greifen in eine Aussparung 442 im Bereich der Aufnahmenut 441 ein (siehe Fig. 16), um thermisch mit dem Bund 452 des jeweiligen Kontaktelements 45 zu kontaktieren.

Um die Öffnung 411 herum sind Kontaktfedern 413 gruppiert, die zur elektrischen Kontaktierung mit einem Kontaktelement 46 in Form eines Erdungskontakts dienen. Das Kontaktelement 46 erstreckt sich durch die Öffnung 411 hindurch, liegt mit seinem radial vorstehenden Bund an den zugeordneten Kontaktfedern 413 an und ist somit elektrisch an die Leiterplatte 41 angeschlossen.

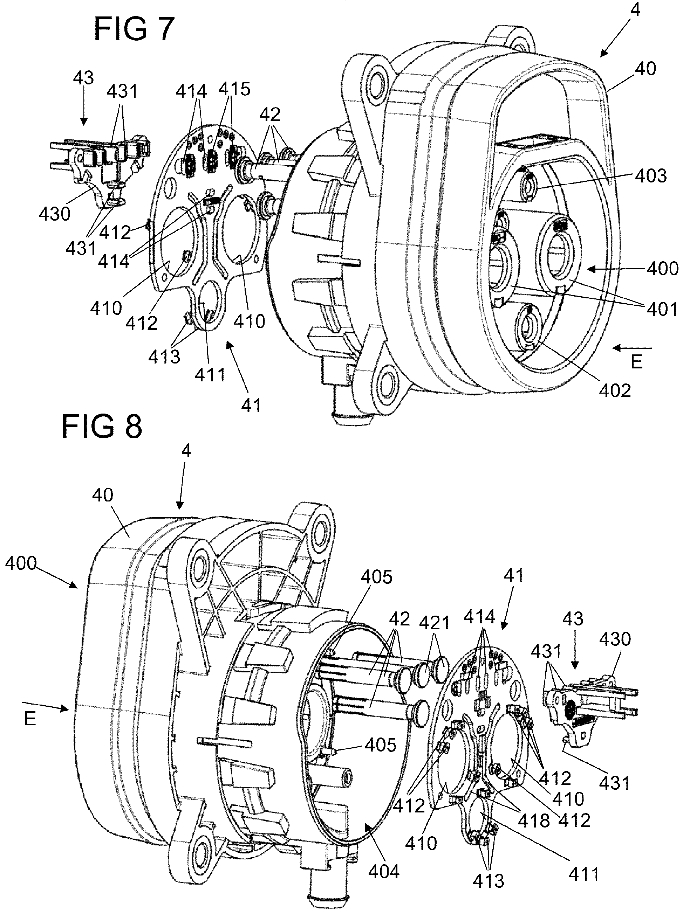

An einer den Kontaktfedern 412, 413 abgewandten Seite der Leiterplatte 41 sind Kontaktfedern 415 angeordnet, die den Kontaktelementen 42 in Form der Signalkontakte zugeordnet sind und die jeweils zwischen einem Paar von Durchgriffsöffnungen 414 angeordnet sind, durch die ein Signalkontaktträger 43 mit Fixierelementen 431 hindurch greift (siehe Fig. 9 und 11 in Zusammenschau mit Fig. 7 und 8). Der Signalkontaktträger 43 ist mit einem Flächenabschnitt 430 an die den Signalkontakten 42 abgewandte Seite der Leiterplatte 41 angesetzt und greift mit den Fixierelementen 431 durch die Durchgriffsöffnungen 414 der Leiterplatte 41 hindurch derart, dass über die Fixierelemente 431 die Kontaktelemente 42 in Form der Signalkontakte axial in Position in den Steckdomen 403 des Steckgesichts 400 gehalten werden. Die Fixierelemente 431 wirken hierzu auf Enden 421 der Kontaktelemente 42 in Form der Signalkontakte ein und sperren diese somit axial in den Steckdomen 43.

Über die Kontaktfedern 415 sind die Kontaktelemente 42 in Form der Signalkontakte elektrisch an die Leiterplatte 41 angebunden. Über die Leiterplatte 41 wird eine Widerstandskodierung an dem Steckverbinderteil 4 bereitgestellt, indem über die elektrische Kontaktierung eines der Kontaktelemente 42 in Form der Signalkontakte und des Kontaktelements 46 in Form des Erdungskontakts ein elektrischer Widerstand 416 (siehe Fig. 14) zwischen die Kontaktelemente 42, 46 geschaltet wird, zum Beispiel zwischen ein einen Näherungskontakt ausbildendes Kontaktelement 42 und das Kontaktelement 46 in Form des Erdungskontakts.

Zudem können an die Leiterplatte 41 Anschlussleitungen 420 angeschlossen sein, über die die Kontaktelemente 42 elektrisch mit einer übergeordneten Baugruppe, zum Beispiel einer übergeordneten Steuereinrichtung, verbunden sind (siehe Fig. 14). Anschlussleitungen 420 können somit über die Leiterplatte 41 geführt werden, was ein direktes Verbinden der Anschlussleitungen 420 mit den zugeordneten Kontaktelementen 42 überflüssig macht und somit die Montage des Steckverbinderteils 4 vereinfacht.

Der Signalkontraktträger 43 ist fest mit dem Lastkontaktträger 44 verbunden und über den Lastkontaktträger 44 zu dem Gehäuseteil 40 festgelegt. Der Signalkontaktträger 43 greift, wie beschrieben, mit seinen Fixierelementen 431 durch die zugeordneten Durchgriffsöffnungen 414 zum Einwirken auf die Kontaktelemente 42. Zudem durchgreift der Lastkontaktträger 44 mit Durchgriffsstegen 443 zugeordnete schlitzförmige Durchgriffsöffnungen 418, wie dies aus Fig. 16 in Zusammenschau zum Beispiel mit Fig. 11 und 14 ersichtlich ist. Die Leiterplatte 41 ist auf diese Weise - zumindest während der Montage - axial schwimmend an dem Signalkontaktträger 43 und dem Lastkontaktträger 44 gelagert, wobei die Leiterplatte 41 elastisch über die Kontaktfedern 412, 413, 415 beidseits der Leiterplatte 41 in Position in dem Gehäuseteil 40 gehalten wird.

Zur Montage des Steckverbinderteils 4 wird die Leiterplatte 41 zusammen mit dem Signalkontaktträger 43 und dem Lastkontaktträger 44 in den Aufnahmeraum 404 des Gehäuseteils 40 eingesetzt derart, dass die Leiterplatte 41 mit den Kontaktfedern 415 in Anlage mit den Enden 421 der Kontaktelemente 42 gelangt. Bei der Montage nimmt die Leiterplatte 41 somit - unter elastischer Vorspannung der Kontaktfedern 412, 413, 415 - eine Zwischenlage zwischen den Kontaktelementen 42 einerseits und den Kontaktelementen 45, 46 andererseits ein, sodass die Leiterplatte 41 unter elastischer Vorspannung der Kontaktfedern 412, 413, 415 axial in Position gehalten ist. Aufgrund der Elastizität der Kontaktfedern 412, 413, 415 können Toleranzen in der Materialstärke der Leiterplatte 41 ausgeglichen werden, was die Montage des Steckverbinderteils 4 unempfindlich gegenüber Toleranzen macht.

Nach der Montage wird die Leiterplatte 41 über an dem Gehäuseteil 40 angeordneten Befestigungsdomen 405 innerhalb des Aufnahmeraums 404 festgelegt, indem die Befestigungsdome 405 verstemmt werden und die Leiterplatte 41 dadurch zu dem Gehäuseteil 40 festgelegt wird.

Weil die Leiterplatte 41 sich senkrecht zur Erstreckungsrichtung der Kontaktelemente 42, 45, 46, 47 in dem Aufnahmeraum 404 des Gehäuseteils 40 erstreckt, ergibt sich eine bauraumeffiziente Anordnung der Leiterplatte 41 in dem Gehäuseteil 40, bei zudem einfacher Montage des Steckverbinderteils 4 und zuverlässiger thermischer und/oder elektrischer Kontaktierung mit den zugeordneten Kontaktelementen 42, 45, 46. Insbesondere wird über die Leiterplatte 41 auch das Schaffen einer vormontierten Baugruppe ermöglicht, im Rahmen derer insbesondere Anschlussleitungen 420 an der Leiterplatte 41 vormontiert sein können. Das Erfordernis für ein direktes Anschließen von Anschlussleitungen 420 an zugeordnete Kontaktelemente 42, zum Beispiel durch Vercrimpen, entfällt.

Der der Erfindung zugrunde liegende Gedanke ist nicht auf die vorangehend geschilderten Ausführungsbeispiele beschränkt, sondern lässt sich grundsätzlich auch in gänzlich andersgearteter Weise verwirklichen.

Ein Steckverbinderteil der hier beschriebenen Art kann vorteilhaft in einem Ladesystem zum Aufladen eines Elektrofahrzeugs verwendet werden. Das Steckverbinderteil kann hierbei eine Ladebuchse (wie bei den dargestellten Ausführungsbeispielen) oder auch einen Ladestecker verwirklichen.

Denkbar ist aber auch eine andere Verwendung. Grundsätzlich ist ein Steckverbinderteil der beschriebenen Art überall dort einsetzen, wo eine Temperaturüberwachung an Kontaktelementen wünschenswert ist.

### Bezugszeichenliste

- 1: Fahrzeug
- 2: Ladestation
- 3: Ladekabel
- 30, 31: Ladestecker
- 4: Steckverbinderteil
- 40: Gehäuseteil
- 400: Steckgesicht
- 401-403: Steckdome
- 404: Aufnahmeraum
- 405: Befestigungsdome
- 41: Leiterplatte
- 410,411: Öffnung
- 412,413: Kontaktfeder
- 414: Durchgriffsöffnung
- 415: Kontaktfeder
- 416: Widerstand
- 417: Temperatursensor
- 418: Durchgriffsöffnung
- 42: Signalkontakte
- 420: Anschlussleitung
- 421: Ende
- 43: Signalkontaktträger
- 430: Flächenabschnitt
- 431: Fixierelemente
- 44: Lastkontaktträger
- 440: Aufnahmeeinrichtung
- 441: Aufnahmenut
- 442: Aussparung
- 443: Durchgriffssteg
- 45: Lastkontakte
- 450: Buchsenabschnitt
- 451: Schaftabschnitt
- 452: Bund
- 453: Anschlussende
- 46: Erdungskontakt (PE-Kontakt)
- 47: Signalkontakt
- E: Steckrichtung

## Patentansprüche

1. Steckverbinderteil (4) zum steckenden Verbinden mit einem zugeordneten Gegensteckverbinderteil (30, 31) für ein Ladesystem zum Aufladen eines Elektrofahrzeugs, mit einem Gehäuseteil (40), einem an dem Gehäuseteil (40) geformten Steckgesicht (400), über das das Steckverbinderteil (4) steckend mit dem Gegensteckverbinderteil (30, 31) verbindbar ist und an dem eine Mehrzahl von Kontaktelementen (42, 45, 46, 47) zum elektrischen Verbinden mit dem Gegensteckverbinderteil (30, 31) angeordnet ist, mit einer Leiterplatte (41), an der zumindest eine elektrische oder elektronische Funktionskomponente (416, 417) angeordnet ist, und mit einem mit dem Gehäuseteil (40) verbundenen Lastkontaktträger (44), an dem ein erstes Kontaktelement (45) der Mehrzahl von Kontaktelementen (42, 45, 46, 47) angeordnet ist, wobei die Leiterplatte (41) eine erste Öffnung (410) aufweist, durch die das erste Kontaktelement (45) hindurch erstreckt ist, wobei die Leiterplatte (41) zumindest eine erste Kontaktfeder (412) zum thermischen und/oder elektrischen Kontaktieren mit dem ersten Kontaktelement (45) und zumindest eine zweite Kontaktfeder (415) zum thermischen und/oder elektrischen Kontaktieren mit einem zweiten Kontaktelement (42) der Mehrzahl von Kontaktelementen (42, 45, 46, 47) aufweist, **gekennzeichnet durch** einen Signalkontaktträger (43), der die Leiterplatte (41) zur Fixierung des zweiten Kontaktelements (42) an dem Gehäuseteil (40) an einer ersten Durchgriffsöffnung (414) durchgreift, wobei zur Montage des Steckverbinderteils (4) die Leiterplatte (41) zusammen mit dem Signalkontaktträger (43) und dem Lastkontaktträger (44) in einen Aufnahmeraum (404) des Gehäuseteils (40) eingesetzt ist derart, dass die Leiterplatte (41) mit der zumindest einen zweiten Kontaktfeder (415) in Anlage mit einem Ende (421) des zumindest einen zweiten Kontaktelements (42) gelangt ist.

2. Steckverbinderteil (4) nach Anspruch 1, **dadurch gekennzeichnet, dass** die zumindest eine erste Kontaktfeder (412) und die zumindest eine zweite Kontaktfeder (415) an unterschiedlichen Seiten der Leiterplatte (41) angeordnet sind.

3. Steckverbinderteil (4) nach Anspruch 1 oder 2, **dadurch gekennzeichnet, dass** das erste Kontaktelement (45) einen die erste Öffnung (410) der Leiterplatte (41) durchgreifenden Schaftabschnitt (451) und einen an dem Schaftabschnitt (451) angeordneten Bund (452) aufweist, wobei die zumindest eine erste Kontaktfeder (415) den Bund (452) des ersten Kontaktelements (45) thermisch und/oder elektrisch kontaktiert.

4. Steckverbinderteil (4) nach Anspruch 3, **dadurch gekennzeichnet, dass** die Leiterplatte (41) über die zumindest eine erste Kontaktfeder (412) und die zumindest eine zweite Kontaktfeder (415) zwischen dem Bund (452) des ersten Kontaktelements (45) und einem Ende (421) des zweiten Kontaktelements (42) elastisch federnd in Position gehalten ist.

5. Steckverbinderteil (4) nach einem der vorangehenden Ansprüche, **dadurch gekennzeichnet, dass** das erste Kontaktelement (45) einen Lastkontakt zum Übertragen eines Laststroms verwirklicht.

6. Steckverbinderteil (4) nach einem der vorangehenden Ansprüche, **dadurch gekennzeichnet, dass** die zumindest eine erste Kontaktfeder (412) das erste Kontaktelement (45) thermisch mit der Leiterplatte (41) verbindet, wobei die Leiterplatte (41) einen Temperatursensor (417) zum Erfassen einer Erwärmung an dem ersten Kontaktelement (45) aufweist.

7. Steckverbinderteil (4) nach einem der vorangehenden Ansprüche, **dadurch gekennzeichnet, dass** das zweite Kontaktelement (42) einen Signalkontakt zum Übertragen von Steuersignalen verwirklicht.

8. Steckverbinderteil (4) nach einem der vorangehenden Ansprüche, **dadurch gekennzeichnet, dass** die zumindest eine zweite Kontaktfeder (415) das zweite Kontaktelement (42) elektrisch mit der Leiterplatte (41) verbindet, wobei die Leiterplatte (41) einen elektrischen Widerstand (416) zum Bereitstellen einer Widerstandskodierung aufweist.

9. Steckverbinderteil (4) nach einem der vorangehenden Ansprüche, **dadurch gekennzeichnet, dass** die zumindest eine zweite Kontaktfeder (415) das zweite Kontaktelement (42) elektrisch mit der Leiterplatte (41) verbindet, wobei zumindest eine Anschlussleitung (420) an die Leiterplatte (41) angeschlossen und elektrisch über die zumindest eine zweite Kontaktfeder (415) mit dem zweiten Kontaktelement (42) verbunden ist.

10. Steckverbinderteil (4) nach einem der vorangehenden Ansprüche, **dadurch gekennzeichnet, dass** die Leiterplatte (41) eine zweite Öffnung (411) aufweist, durch die ein drittes Kontaktelement (46) hindurch erstreckt ist, wobei die Leiterplatte (41) zumindest eine dritte Kontaktfeder (413) zum thermischen und/oder elektrischen Kontaktieren mit dem dritten Kontaktelement (46) aufweist.

11. Steckverbinderteil (4) nach Anspruch 10, **dadurch gekennzeichnet, dass** das dritte Kontaktelement (46) einen Erdungskontakt verwirklicht.

12. Steckverbinderteil (4) nach Anspruch 10 oder 11, **dadurch gekennzeichnet, dass** die zumindest eine dritte Kontaktfeder (413) das dritte Kontaktelement (46) elektrisch mit der Leiterplatte (41) verbindet, wobei die Leiterplatte (41) das zweite Kontaktelement (42) und das dritte Kontaktelement (46) zur Bereitstellung einer Widerstandskodierung über einen elektrischen Widerstand (416) miteinander verbindet.

13. Steckverbinderteil (4) nach einem der Ansprüche 1 bis 12, **dadurch gekennzeichnet, dass** der Lastkontaktträger (44) die Leiterplatte (41) an einer zweiten Durchgriffsöffnung (418) durchgreift.

## Claims

1. Plug-in connector part (4) for plug-connection to an associated mating plug-in connector part (30, 31) for a charging system for charging an electric vehicle, comprising a housing part (40), a plug-in face (400) which is formed on the housing part (40) and by means of which the plug-in connector part (4) can be plug-connected to the mating plug-in connector part (30, 31) and on which a plurality of contact elements (42, 45, 46, 47) for electrical connection to the mating plug-in connector part (30, 31) are arranged, comprising a printed circuit board (41) on which at least one electrical or electronic functional component (416, 417) is arranged, and comprising a load contact carrier (44) which is connected to the housing part (40) and on which a first contact element (45) of the plurality of contact elements (42, 45, 46, 47) is arranged, wherein the printed circuit board (41) has a first opening (410) through which the first contact element (45) is extended, wherein the printed circuit board (41) has at least one first contact spring (412) for making thermal and/or electrical contact with the first contact element (45) and at least one second contact spring (415) for making thermal and/or electrical contact with a second contact element (42) of the plurality of contact elements (42, 45, 46, 47), **characterized by** a signal contact carrier (43) which passes through the printed circuit board (41) at a first passage opening (414) for fixing the second contact element (42) to the housing part (40), wherein, for the purpose of assembling the plug-in connector part (4), the printed circuit board (41), together with the signal contact carrier (43) and the load contact carrier (44), is inserted into a receiving space (404) of the housing part (40) in such a way that the printed circuit board (41), by way of the at least one second contact spring (415), comes in contact with an end (421) of the at least one second contact element (42).

2. Plug-in connector part (4) according to Claim 1, **characterized in that** the at least one first contact spring (412) and the at least one second contact spring (415) are arranged on different sides of the printed circuit board (41).

3. Plug-in connector part (4) according to Claim 1 or 2, **characterized in that** the first contact element (45) has a shaft portion (451) which passes through the first opening (410) of the printed circuit board (41) and has a collar (452) which is arranged on the shaft portion (451), wherein the at least one first contact spring (415) makes thermal and/or electrical contact with the collar (452) of the first contact element (45).

4. Plug-in connector part (4) according to Claim 3, **characterized in that** the printed circuit board (41) is held in position in an elastically resilient manner between the collar (452) of the first contact element (45) and an end (421) of the second contact element (42) by means of the at least one first contact spring (412) and the at least one second contact spring (415).

5. Plug-in connector part (4) according to one of the preceding claims, **characterized in that** the first contact element (45) implements a load contact for transmitting a load current.

6. Plug-in connector part (4) according to one of the preceding claims, **characterized in that** the at least one first contact spring (412) thermally connects the first contact element (45) to the printed circuit board (41), wherein the printed circuit board (41) has a temperature sensor (417) for detecting heating at the first contact element (45).

7. Plug-in connector part (4) according to one of the preceding claims, **characterized in that** the second contact element (42) implements a signal contact for transmitting control signals.

8. Plug-in connector part (4) according to one of the preceding claims, **characterized in that** the at least one second contact spring (415) electrically connects the second contact element (42) to the printed circuit board (41), wherein the printed circuit board (41) has an electrical resistor (416) for providing resistor coding.

9. Plug-in connector part (4) according to one of the preceding claims, **characterized in that** the at least one second contact spring (415) electrically connects the second contact element (42) to the printed circuit board (41), wherein at least one connection line (420) is connected to the printed circuit board (41) and electrically connected to the second contact element (42) by means of the at least one second contact spring (415) .

10. Plug-in connector part (4) according to one of the preceding claims, **characterized in that** the printed circuit board (41) has a second opening (411) through which a third contact element (46) is extended, wherein the printed circuit board (41) has at least one third contact spring (413) for making thermal and/or electrical contact with the third contact element (46).

11. Plug-in connector part (4) according to Claim 10, **characterized in that** the third contact element (46) implements an earthing contact.

12. Plug-in connector part (4) according to Claim 10 or 11, **characterized in that** the at least one third contact spring (413) electrically connects the third contact element (46) to the printed circuit board (41), wherein the printed circuit board (41) connects the second contact element (42) and the third contact element (46) to one another by means of an electrical resistor (416) for providing resistor coding.

13. Plug-in connector part (4) according to one of Claims 1 to 12, **characterized in that** the load contact carrier (44) passes through the printed circuit board (41) at a second passage opening (418).

## Revendications

1. Pièce de connecteur enfichable (4) destinée à être connectée par enfichage à une pièce de connecteur enfichable complémentaire (30, 31) associée pour un système de charge servant à recharger un véhicule électrique, comportant une partie de boîtier (40), une face d'enfichage (400) formée sur la partie de boîtier (40), face d'enfichage par le biais de laquelle la pièce de connecteur enfichable (4) peut être connectée par enfichage à la pièce de connecteur enfichable complémentaire (30, 31) et sur laquelle une pluralité d'éléments de contact (42, 45, 46, 47) servant à la connexion électrique à la pièce de connecteur enfichable complémentaire (30, 31) sont disposés, comportant une carte de circuit imprimé (41), sur laquelle est disposé au moins un composant fonctionnel (416, 417) électrique ou électronique, et comportant un support de contact de charge (44) connecté à la partie de boîtier (40), support sur lequel est disposé un premier élément de contact (45) de la pluralité d'éléments de contact (42, 45, 46, 47), la carte de circuit imprimé (41) comprenant une première ouverture (410) à travers laquelle s'étend le premier élément de contact (45), la carte de circuit imprimé (41) comprenant au moins un premier ressort de contact (412) pour la mise en contact thermique et/ou électrique avec le premier élément de contact (45) et au moins un deuxième ressort de contact (415) pour la mise en contact thermique et/ou électrique avec un deuxième élément de contact (42) de la pluralité d'éléments de contact (42, 45, 46, 47), **caractérisée par** un support de contact de signaux (43) qui vient en prise à travers la carte de circuit imprimé (41) pour la fixation du deuxième élément de contact (42) sur la partie de boîtier (40) au niveau d'une première ouverture d'entrée en prise (414), la carte de circuit imprimé (41) étant, pour le montage de la pièce de connecteur enfichable (4), insérée conjointement avec le support de contact de signaux (43) et le support de contact de charge (44) dans un espace de réception (404) de la partie de boîtier (40), de telle sorte que la carte de circuit imprimé (41) vienne en appui, par l'au moins un deuxième ressort de contact (415), contre une extrémité (421) de l'au moins un deuxième élément de contact (42).

2. Pièce de connecteur enfichable (4) selon la revendication 1, **caractérisée en ce que** l'au moins un premier ressort de contact (412) et l'au moins un deuxième ressort de contact (415) sont disposés sur des côtés différents de la carte de circuit imprimé (41).

3. Pièce de connecteur enfichable (4) selon la revendication 1 ou 2, **caractérisée en ce que** le premier élément de contact (45) comprend une première partie de tige (451) venant en prise à travers la première ouverture (410) de la carte de circuit imprimé (41) et un collet (452) disposé sur la partie de tige (451), l'au moins un premier ressort de contact (415) venant en contact thermiquement et/ou électriquement avec le collet (452) du premier élément de contact (45).

4. Pièce de connecteur enfichable (4) selon la revendication 3, **caractérisée en ce que** la carte de circuit imprimé (41) est maintenue élastiquement en position par le biais de l'au moins un premier ressort de contact (412) et de l'au moins un deuxième ressort de contact (415) entre le collet (452) du premier élément de contact (45) et une extrémité (421) du deuxième élément de contact (42).

5. Pièce de connecteur enfichable (4) selon l'une des revendications précédentes, **caractérisée en ce que** le premier élément de contact (45) réalise un contact de charge pour la transmission d'un courant de charge.

6. Pièce de connecteur enfichable (4) selon l'une des revendications précédentes, **caractérisée en ce que** l'au moins un premier ressort de contact (412) connecte le premier élément de contact (45) thermiquement à la carte de circuit imprimé (41), la carte de circuit imprimé (41) comprenant un capteur de température (417) servant à la détection d'un échauffement au niveau du premier élément de contact (45).

7. Pièce de connecteur enfichable (4) selon l'une des revendications précédentes, **caractérisée en ce que** le deuxième élément de contact (42) réalise un contact de signaux pour la transmission de signaux de commande.

8. Pièce de connecteur enfichable (4) selon l'une des revendications précédentes, **caractérisée en ce que** l'au moins un deuxième ressort de contact (415) connecte le deuxième élément de contact (42) électriquement à la carte de circuit imprimé (41), la carte de circuit imprimé (41) comprenant une première résistance électrique (416) pour produire un codage par résistance.

9. Pièce de connecteur enfichable (4) selon l'une des revendications précédentes, **caractérisée en ce que** l'au moins un deuxième ressort de contact (415) connecte le deuxième élément de contact (42) électriquement à la carte de circuit imprimé (41), au moins une ligne de raccordement (420) étant raccordée à la carte de circuit imprimé (41) et étant connectée électriquement au deuxième élément de contact (42) par le biais de l'au moins un deuxième ressort de contact (415).

10. Pièce de connecteur enfichable (4) selon l'une des revendications précédentes, **caractérisée en ce que** la carte de circuit imprimé (41) comprend une deuxième ouverture (411) à travers laquelle s'étend un troisième élément de contact (46), la carte de circuit imprimé (41) comprenant au moins un troisième ressort de contact (413) pour la mise en contact thermique et/ou électrique avec le troisième élément de contact (46).

11. Pièce de connecteur enfichable (4) selon la revendication 10, **caractérisée en ce que** le troisième élément de contact (46) réalise un contact de terre.

12. Pièce de connecteur enfichable (4) selon la revendication 10 ou 11, **caractérisée en ce que** l'au moins un troisième ressort de contact (413) connecte le troisième élément de contact (46) électriquement à la carte de circuit imprimé (41), la carte de circuit imprimé (41) connectant l'un à l'autre le deuxième élément de contact (42) et le troisième élément de contact (46) par le biais d'une résistance électrique (416) pour produire un codage par résistance.

13. Pièce de connecteur enfichable (4) selon l'une des revendications 1 à 12, **caractérisée en ce que** le support de contact de charge (44) vient en prise à travers la carte de circuit imprimé (41) au niveau d'une deuxième ouverture d'entrée en prise (418).
